(19) Europäisches Patentamt
European Patent Office
Office européen des brevets

(11) **EP 3 378 897 B1**

(12) **EUROPEAN PATENT SPECIFICATION**

(45) Date of publication and mention of the grant of the patent:
**05.08.2020 Bulletin 2020/32**

(21) Application number: **16866369.8**

(22) Date of filing: **17.11.2016**

(51) Int Cl.:
***C08L 63/00*** *(2006.01)* ***C08K 3/22*** *(2006.01)*
***C08K 3/36*** *(2006.01)* ***C08G 59/30*** *(2006.01)*
***C08G 59/42*** *(2006.01)* ***C08G 59/50*** *(2006.01)*
***C08G 59/68*** *(2006.01)* ***H01L 23/29*** *(2006.01)*

(86) International application number:
**PCT/JP2016/084031**

(87) International publication number:
**WO 2017/086368 (26.05.2017 Gazette 2017/21)**

(54) **EPOXY RESIN COMPOSITION, METHOD FOR PRODUCING SAME, AND USE OF COMPOSITION**

EPOXIDHARZZUSAMMENSETZUNG, VERFAHREN ZUR HERSTELLUNG DAVON UND VERWENDUNG DER ZUSAMMENSETZUNG

COMPOSITION DE RÉSINE ÉPOXY, PROCÉDÉ POUR SA PRODUCTION ET UTILISATION DE LA COMPOSITION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.11.2015 JP 2015226054**
**19.02.2016 JP 2016030414**

(43) Date of publication of application:
**26.09.2018 Bulletin 2018/39**

(73) Proprietor: **Sumitomo Seika Chemicals Co., Ltd.**
**Hyogo 675-0145 (JP)**

(72) Inventors:
- **FUKUDA, Noriaki**
**Hyogo 675-0145 (JP)**
- **HARISAKI, Ryota**
**Hyogo 675-0145 (JP)**
- **YAMAMOTO, Katsumasa**
**Hyogo 675-0145 (JP)**
- **NEMOTO, Nobukatsu**
**Koriyama-shi**
**Fukushima 963-8803 (JP)**

(74) Representative: **Mewburn Ellis LLP**
**Aurora Building**
**Counterslip**
**Bristol BS1 6BX (GB)**

(56) References cited:
**WO-A1-2006/005369**
**WO-A1-2012/105071**
**WO-A1-2015/041325**
**JP-A- 2003 321 482**
**JP-A- 2004 527 602**
**JP-A- 2008 505 945**
**JP-A- 2009 544 785**
**JP-A- 2010 215 858**
**JP-A- 2012 001 668**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 378 897 B1

## Description

### Technical Field

The present invention relates to an epoxy resin composition, a method for producing the same, and use of the composition.

### Background Art

There has recently been a strong demand for an increase in the volume and speed of semiconductors, and a reduction in the size and thickness of semiconductor packages, along with an increase in the performance of electronic devices, such as tablet terminals, and a reduction in the size and thickness thereof. For semiconductor packaging, mounting techniques such as ball grid arrays (BGA) and chip-size packages (CSP), which are suitable for size reduction and multiple pins, have been used.

In BGA and CSP, contact failure is likely to occur due to the thermal load etc. because the package and the substrate have a small contact area with solder balls inserted between them. Therefore, a liquid sealing material is placed in the gap between the package and the substrate to reduce the load. The size of this gap will become narrower in the future along with further requirements for size reduction of electronic devices. Liquid sealing materials are required to have a low viscosity so that they can be placed in such narrow gaps.

In general, liquid sealing materials comprise a Bis-A or Bis-F liquid epoxy resin and an inorganic filler. However, when a large amount of inorganic filler is contained, the viscosity significantly increases to deteriorate moldability. Accordingly, the currently used method is to reduce the viscosity of liquid sealing materials by adding an organic solvent, such as toluene or methyl ethyl ketone, as a diluent. Another method is to add an epoxy resin with a low viscosity, such as a higher alcohol glycidyl ether compound or a glycol glycidyl ether compound (PTL 1).

The frequency of transmission signals has recently increased along with an increase in the performance of electronic devices and a reduction in the weight and size thereof. In accordance with the increased frequency, materials used in printed circuit boards and semiconductor sealing materials are strongly required to have a lower dielectric constant in the high frequency region. Epoxy resins satisfy performance requirements for electrical insulating properties and heat resistance; however, highly polar hydroxyl groups are generated due to the reaction between epoxy group and active hydrogen, thereby increasing relative dielectric constant. Thus, sufficient electric characteristics (lower dielectric constant etc.) are not obtained.

Moreover, in copper wiring used in substrate materials, the development of low-roughness copper foil and copper plating corresponding to the increased frequency of transmission signals has been advanced. However, if the roughness of copper wiring is low, the anchor effect of copper and epoxy resin is reduced, thereby making it difficult to ensure adhesion strength. For this reason, there is a demand for epoxy resins having sufficient adhesion to copper wiring that has low roughness and a small anchor effect.

Furthermore, cured products absorb moisture upon exposure to severe conditions in various environments, and the various characteristics of the cured products are consequently reduced. Thus, cured products of liquid sealing materials containing an epoxy resin are required to have low water absorption.

PTL 2 reports that a cured product is obtained using a silicon atom-containing epoxy resin and a curing agent.

WO 2006/005369 A1 concerns a dental composition. WO 2012/105071 A1 concerns a resin sealing material for a semiconductor.

### Citation List

#### Patent Literature

PTL 1: JP2012-162585A
PTL 2: GB1123960

### Summary of Invention

#### Technical Problem

However, when an epoxy resin composition is prepared by adding an organic solvent as a diluent to a conventional epoxy resin in order to reduce the viscosity of the epoxy resin, the use of the composition as a liquid sealing

material results in defects, such as void generation and the residual organic solvent in the cured product. Moreover, epoxy resin compositions using the epoxy resin with a low viscosity disclosed in PTL 1 had insufficient flow characteristics. Furthermore, cured products obtained therefrom had insufficient performance in terms of adhesion to metal, water absorption characteristics, electric characteristics, etc.

Accordingly, an object of the present invention is to provide an epoxy resin composition that can achieve a sufficiently low viscosity without using a diluent (an organic solvent), and a method for producing the same. Another object of the present invention is to provide an epoxy resin composition that can preferably achieve, when cured, good electric characteristics (particularly low dielectric constant and low dielectric loss tangent), high adhesion strength to metal, and good water absorption characteristics; and to also provide a method for producing the same.

Solution to Problem

As a result of extensive research to solve the above problems, the present inventor found that an epoxy resin composition comprising a silicon atom-containing epoxy resin and a filler having a low viscosity can be obtained even without using a diluent (an organic solvent). The present invention has been completed upon further studies based on this finding.

Specifically, the present invention includes, for example, an epoxy resin composition comprising a predetermined epoxy resin and a filler, a method for producing the same, and use thereof described below.

Item 1. An epoxy resin composition comprising an epoxy resin, a curing agent and a filler, the epoxy resin being represented by the formula (1):

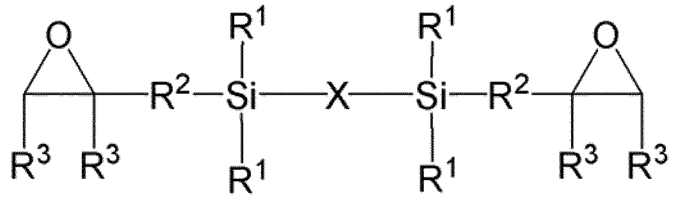

(1)

wherein X is a divalent group obtained by removing two hydrogen atoms from a hydrocarbon ring, or a divalent group represented by the formula (2):

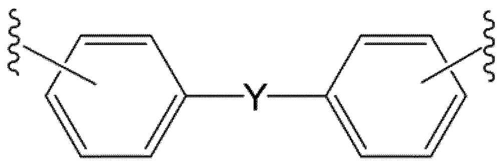

(2)

wherein Y is a bond, a $C_{1-6}$ alkylene group, an oxygen atom (-0-), or $-S(O)_m-$ wherein m is 0, 1, or 2;

$R^1$ is the same or different, and is a $C_{1-18}$ alkyl group, a $C_{2-9}$ alkenyl group, a cycloalkyl group, an aryl group, or an aralkyl group, wherein one or more carbon atoms of these groups may be replaced by at least one atom selected from the group consisting of an oxygen atom and a nitrogen atom;

$R^2$ is the same or different, and is a $C_{1-18}$ alkylene group, wherein one or more carbon atoms of this group other than a carbon atom directly bonded to a silicon atom may be replaced by at least one atom selected from the group consisting of an oxygen atom and a nitrogen atom; and

$R^3$ is the same or different, and is a hydrogen atom, a $C_{1-18}$ alkyl group, a $C_{2-9}$ alkenyl group, a cycloalkyl group, an aryl group, or an aralkyl group, wherein one or more carbon atoms of these groups may be replaced by at least one atom selected from the group consisting of an oxygen atom and a nitrogen atom, and

the curing agent being at least one member selected from the group consisting of acid anhydride-based curing agents and amine-based curing agents.

Item 2. The epoxy resin composition according to Item 1, wherein the epoxy resin is represented by the formula (1a):

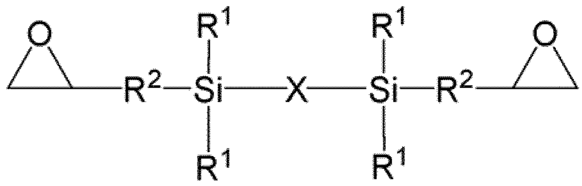

(1a)

wherein $R^1$, $R^2$, and X are as defined above.

Item 3. The epoxy resin composition according to Item 2, wherein X is a 1,4-phenylene group or a group represented by the formula (2a):

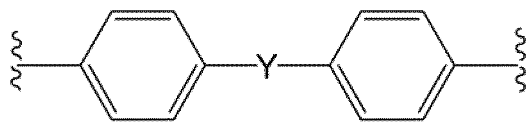

(2a)

wherein Y is as defined above,

$R^1$ is the same or different, and is a $C_{1-3}$ alkyl group, and
$R^2$ is the same or different, and is a $C_{2-6}$ alkylene group, (*)-$(CH_2)_2$-O-$CH_2$-, (*)-$(CH_2)_3$-O-$CH_2$-, (*)-$(CH_2)_3$-O-$(CH_2)_2$-, or (*)-$(CH_2)_5$-O-$(CH_2)_4$-, wherein (*) represents the side of $R^2$ binding to the silicon atom.

Item 4. The epoxy resin composition according to Item 1, 2, or 3, wherein the filler is at least one member selected from the group consisting of alumina, calcium carbonate, crystalline silica, fused silica, spherical fused silica, boron nitride, and talc.
Item 5. A cured product of the epoxy resin composition according to any one of Items 1 to 4.
Item 6. A method for producing the epoxy resin composition according to any one of Items 1 to 4 or the cured product according to Item 5, the method comprising mixing the epoxy resin represented by the formula (1) and the filler.
Item 7. A semiconductor sealing material, a liquid sealing material, a potting material, a sealing material, a printed circuit board material, or a composite material, each of which uses the epoxy resin composition according to any one of Items 1 to 4 or the cured product according to Item 5.
Item 8. The epoxy resin composition according to any one of Items 1 to 4 for use in a semiconductor sealing material, a liquid sealing material, a potting material, a sealing material, a printed circuit board material, or a composite material.
Item 9. Use of the epoxy resin composition according to any one of Items 1 to 4 for producing a semiconductor sealing material, a liquid sealing material, a potting material, a sealing material, a printed circuit board material, or a composite material.
Item 10. Use of an epoxy resin composition comprising an epoxy resin and a filler for producing a semiconductor sealing material, a liquid sealing material, a potting material, a sealing material, a printed circuit board material, or a composite material,
wherein the epoxy resin is represented by the formula (1) :

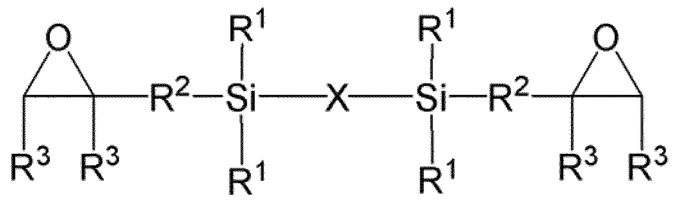

(1)

wherein X is a divalent group obtained by removing two hydrogen atoms from a hydrocarbon ring, or a divalent group represented by the formula (2):

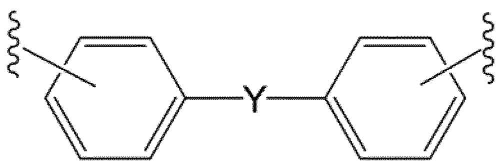

(2)

wherein Y is a bond, a $C_{1-6}$ alkylene group, an oxygen atom (-O-), or $-S(O)_m-$ wherein m is 0, 1, or 2;

$R^1$ is the same or different, and is a $C_{1-18}$ alkyl group, a $C_{2-9}$ alkenyl group, a cycloalkyl group, an aryl group, or an aralkyl group, wherein one or more carbon atoms of these groups may be replaced by at least one atom selected from the group consisting of an oxygen atom and a nitrogen atom;
$R^2$ is the same or different, and is a $C_{1-18}$ alkylene group, wherein one or more carbon atoms of this group other than a carbon atom directly bonded to a silicon atom may be replaced by at least one atom selected from the group consisting of an oxygen atom and a nitrogen atom; and
$R^3$ is the same or different, and is a hydrogen atom, a $C_{1-18}$ alkyl group, a $C_{2-9}$ alkenyl group, a cycloalkyl group, an aryl group, or an aralkyl group, wherein one or more carbon atoms of these groups may be replaced by at least one atom selected from the group consisting of an oxygen atom and a nitrogen atom.

Advantageous Effects of Invention

Because the epoxy resin composition of the present invention comprises a silicon atom-containing epoxy resin represented by the formula (1), it has a low viscosity and good flowability, and a cured product thereof has good electric characteristics, high adhesion strength to metal, and good water absorption characteristics. Therefore, the epoxy resin composition of the present invention can be suitably used for a wide range of applications, such as semiconductor sealing materials, liquid sealing materials, potting materials, sealing materials, printed circuit board materials, and composite materials.

Because the epoxy resin composition of the present invention itself has a low viscosity, it is not necessary to use an organic solvent, such as toluene or methyl ethyl ketone, as a diluent. Therefore, void formation due to the use of organic solvents, residual organic solvents in cured products, and like drawbacks can be avoided.

Moreover, the epoxy resin composition of the present invention has a much lower viscosity and superior adhesion strength to metal, compared with conventional bisphenol-type epoxy resin-containing epoxy resin compositions, polyalkylene glycol diglycidyl ether-containing epoxy resin compositions, etc.

The epoxy resin composition of the present invention can be suitably used particularly for semiconductor sealing materials and liquid sealing materials, such as underfill materials.

Description of Embodiments

In the present specification, the phrase '"containing" or "comprising" a component' means that the component is contained, and that any other components may also be contained. In addition, this phrase includes the concept of "consisting of," which means that only the component is contained, as well as the concept of "consisting essentially of," which means that the component is essentially contained.

The present invention is described in detail below.

The epoxy resin composition of the present invention characteristically comprises an epoxy resin represented by the formula (1) above and a filler.

The epoxy resin used in the present invention has a structure represented by the formula (1). In the formula (1), $R^1$ is the same or different, and is a $C_{1-18}$ alkyl group, a $C_{2-9}$ alkenyl group, a cycloalkyl group, an aryl group, or an aralkyl group, wherein one or more carbon atoms of these groups may be replaced by at least one atom selected from the group consisting of an oxygen atom and a nitrogen atom. The one or more carbon atoms are preferably a carbon atom that is not directly bonded to the silicon atom. The one or more carbon atoms that may be replaced may be one or plural (e.g., 2, 3, 4, 5, or 6) carbon atoms, and preferably one carbon atom. In terms of ease of synthesis, etc., it is preferable that $R^1$ bonded to the same silicon atom be the same, and it is more preferable that all $R^1$ be the same.

The $C_{1-18}$ alkyl group represented by $R^1$ is, for example, a linear or branched alkyl group. Examples include a methyl group, an ethyl group, an n-propyl group, an isopropyl group, an n-butyl group, an isobutyl group, a tert-butyl group, an n-pentyl group, a neopentyl group, a tert-pentyl group, an n-hexyl group, an n-heptyl group, a 2,2,4-trimethylpentyl group, an n-octyl group, an isooctyl group, an n-nonyl group, an n-decyl group, an n-dodecyl group, and the like. Preferable is a $C_{1-10}$ alkyl group, more preferable is a $C_{1-6}$ alkyl group, even more preferable is a $C_{1-3}$ alkyl group, and particularly preferable is a methyl group.

The $C_{2-9}$ alkenyl group represented by $R^1$ is, for example, a linear or branched alkenyl group. Examples include a vinyl group, an allyl group, a 2-propenyl group, a butenyl group, a pentenyl group, a hexenyl group, a heptenyl group, an octenyl group, a nonenyl group, and the like. Preferable is a $C_{2-4}$ alkenyl group.

The cycloalkyl group represented by $R^1$ is, for example, a 3- to 8-membered-ring cycloalkyl group. Examples include a cyclopentyl group, a cyclohexyl group, a cycloheptyl group, a methylcyclohexyl group, and the like.

The aryl group represented by $R^1$ is, for example, a monocyclic or bicyclic aryl group. Examples include a phenyl group, a tolyl group, a xylyl group, an ethyl phenyl group, a naphthyl group, and the like. Preferable among them

is a phenyl group.

The aralkyl group represented by $R^1$ is, for example, a $C_{1-4}$ alkyl group substituted with an aryl group (particularly a phenyl group). Examples include a benzyl group, an $\alpha$-phenethyl group, a $\beta$-phenethyl group, a $\beta$-methylphenethyl group, and the like.

$R^1$ is preferably a $C_{1-3}$ alkyl group, and more preferably a methyl group.

In the formula (1), $R^3$ is the same or different, and is a hydrogen atom, a $C_{1-18}$ alkyl group, a $C_{2-9}$ alkenyl group, a cycloalkyl group, an aryl group, or an aralkyl group, wherein one or more carbon atoms of these groups may be replaced by at least one atom selected from the group consisting of an oxygen atom and a nitrogen atom. The one or more carbon atoms are preferably a carbon atom that is not directly bonded to the epoxy ring. The one or more carbon atoms that may be replaced may be one or plural (e.g., 2, 3, 4, 5, or 6) carbon atoms, and preferably one carbon atom.

Examples of the $C_{1-18}$ alkyl group, $C_{2-9}$ alkenyl group, cycloalkyl group, aryl group, and aralkyl group represented by $R^3$ include the same corresponding substituents represented by $R^1$ described above.

$R^3$ is preferably a hydrogen atom or a $C_{1-3}$ alkyl group, and more preferably a hydrogen atom.

In the formula (1), $R^2$ is the same or different, and is a $C_{1-18}$ alkylene group. The alkylene group is a linear or branched alkylene group, and preferably a linear alkylene group. Specifically, the alkylene group is preferably a $C_{2-18}$ alkylene group, more preferably a $C_{2-10}$ alkylene group, even more preferably a $C_{2-8}$ alkylene group, still more preferably a $C_{2-6}$ alkylene group, and particularly preferably a $C_{2-5}$ alkylene group. More specific examples include a methylene group, a methylmethylene group, an ethylmethylene group, a dimethylmethylene group, a diethylmethylene group, a dimethylene group ($-CH_2CH_2-$), a trimethylene group ($-CH_2CH_2CH_2-$), a tetramethylene group, a pentamethylene group, a hexamethylene group, a heptamethylene group, an octamethylene group, a nonamethylene group, a decamethylene group, an undecamethylene group, a dodecamethylene group, a tridecamethylene group, and the like.

In the $C_{1-18}$ alkylene group, one or more carbon atoms may be replaced by at least one atom selected from the group consisting of an oxygen atom and a nitrogen atom (preferably an oxygen atom). The one or more carbon atoms are preferably a carbon atom that is not directly bonded to the silicon atom or the epoxy ring. The one or more carbon atoms that may be replaced may be one or plural (e.g., 2, 3, 4, 5, or 6) carbon atoms, and preferably one carbon atom.

Examples of this group, when the side of $R^2$ binding to the silicon atom is regarded as (*), include (*)-$C_{2-9}$ alkylene-O-$C_{1-8}$ alkylene-, preferably (*)-$C_{2-4}$ alkylene-O-$C_{1-3}$ alkylene-, more preferably (*)-$C_{2-4}$ alkylene-O-$C_{1-2}$ alkylene-, and particularly preferably (*)-$C_3$ alkylene-O-methylene-.

Specific examples include (*)-$(CH_2)_2$-O-$CH_2$-, (*)-$(CH_2)_3$-O-$CH_2$-, (*)-$(CH_2)_3$-O-$(CH_2)_2$-, (*)-$(CH_2)_5$-O-$(CH_2)_4$-, and the like; preferable among these is (*)-$(CH_2)_3$-O-$CH_2$-.

In the formula (1), the "hydrocarbon ring" of the divalent group represented by X obtained by removing two hydrogen atoms from a hydrocarbon ring is a monocyclic or polycyclic (particularly bicyclic or tricyclic) aliphatic hydrocarbon ring, or a monocyclic or polycyclic aromatic hydrocarbon ring. Examples include a cyclopentane ring, a cyclohexane ring, a tetralin ring, a decahydronaphthalene ring, a 1,2,3,4,5,6,7,8-octahydronaphthalene ring, a norbornene ring, an adamantane ring, a benzene ring, a toluene ring, a xylene ring, a naphthalene ring, a phenanthrene ring, an anthracene ring, a pyrene ring, a triphenylene ring, and the like. Preferable are a cyclohexane ring and a benzene ring. The divalent group represented by X is preferably a cyclohexane-1,4-diyl group or a 1,4-phenylene group; and more preferably a 1,4-phenylene group.

In the formula (2), the $C_{1-6}$ alkylene group represented by Y is, for example, a chain or branched alkylene group. Examples include a methylene group, a methylmethylene group, an ethylmethylene group, a dimethylmethylene group, a diethylmethylene group, a dimethylene group ($-CH_2CH_2-$), a trimethylene group ($-CH_2CH_2CH_2-$), and the like.

Y is preferably a bond, an oxygen atom, a methylene group, a dimethylmethylene group, -S-, or $-SO_2-$; and more preferably a bond, a dimethylmethylene group, an oxygen atom, or $-SO_2^-$.

Preferable among the divalent groups represented by the formula (2) is a group represented by the formula (2a):

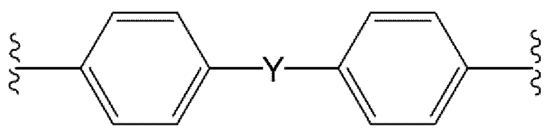 (2a)

wherein Y is as defined above.

In the formula (2a), Y is preferably a bond, a dimethylmethylene group, an oxygen atom, or $-SO_2-$.

Preferable among the epoxy resins represented by the formula (1) is a compound represented by the formula (1a):

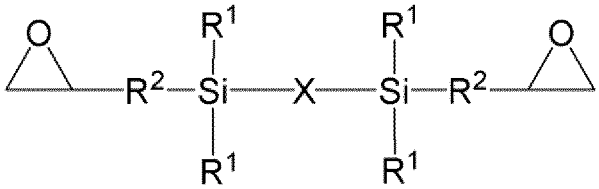

(1a)

wherein $R^1$, $R^2$, and X are as defined above.

Preferable among the compounds represented by the formula (1a) is a compound wherein X is a 1,4-phenylene group or a group represented by the formula (2a) (preferably a 1,4-phenylene group), $R^1$ is the same or different (preferably the same), and is a $C_{1-3}$ alkyl group (particularly a methyl group), and $R^2$ is the same or different (preferably the same), and is a $C_{2-6}$ alkylene group, (*)-$(CH_2)_2$-O-$CH_2$-, (*)-$(CH_2)_3$-O-$CH_2$-, (*)-$(CH_2)_3$-O-$(CH_2)_2$-, or (*)-$(CH_2)_5$-O-$(CH_2)_4$-. (*) represents the side of $R^2$ binding to the silicon atom, as stated above.

More preferable among the epoxy resins represented by the formula (1a) is a compound represented by the formula (1b):

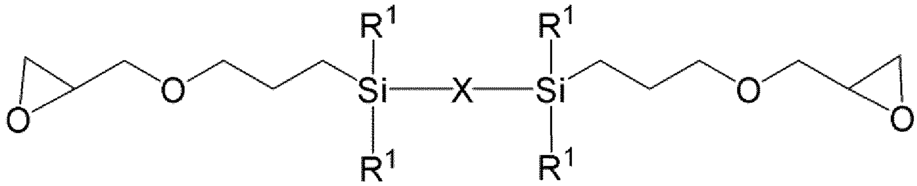

(1b)

wherein $R^1$ and X are as defined above, or the formula (1c):

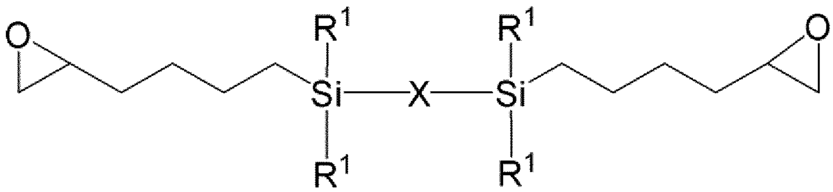

(1c)

wherein $R^1$ and X are as defined above.

It is preferable that in the formula (1b) or (1c), $R^1$ be the same or different (preferably the same), and be a $C_{1-3}$ alkyl group (particularly a methyl group), and X be a 1,4-phenylene group or a group represented by the formula (2a).

The epoxy resin represented by the formula (1) (including the epoxy resins represented by the formulas (1a), (1b), and (1c)) can be produced by a known method, for example, based on or according to the disclosure of PTL 2 etc. As a specific example, the epoxy resin can be produced by the following reaction formula.

Reaction formula

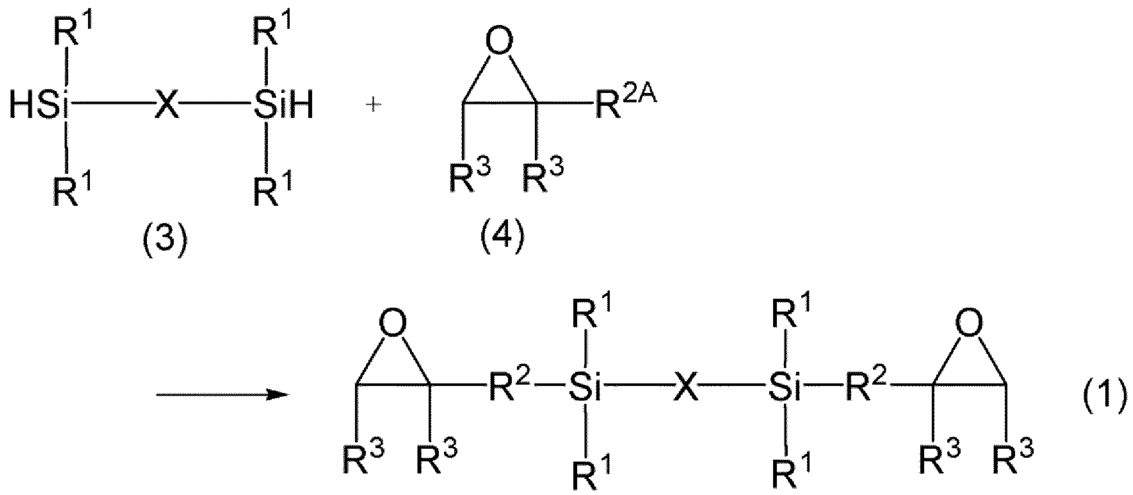

(3) (4) (1)

wherein $R^{2A}$ is a $C_{2-18}$ alkenyl group, wherein one or more carbon atoms of this group may be replaced by at least one atom selected from the group consisting of an oxygen atom and a nitrogen atom; and $R^1$, $R^2$, $R^3$, and X are as defined above.

The $C_{2-18}$ alkenyl group represented by $R^{2A}$ is a linear or branched alkenyl group, and preferably a linear alkenyl group. Specific examples include a vinyl group, an allyl group, a propenyl group, a butenyl group, a pentenyl group, a hexenyl group, a heptenyl group, an octenyl group, a norbornenyl group, a cyclohexenyl group, and the like. Preferable is a $C_{2-10}$ alkenyl group, more preferable is a $C_{2-8}$ alkenyl group, even more preferable is a $C_{2-6}$ alkenyl group, and particularly preferable is a vinyl group, an allyl group, or a butenyl group. Regarding the double bond position between carbon atoms, the alkenyl group is preferably an $\alpha$-alkenyl group.

One or more carbon atoms of these $C_{2-18}$ alkenyl groups may be replaced by at least one atom selected from the group consisting of an oxygen atom and a nitrogen atom (preferably an oxygen atom). The one or more carbon atoms are preferably a carbon atom that is not directly bonded to the epoxy ring. The one or more carbon atoms that may be replaced may be one or plural (e.g., 2, 3, 4, 5, or 6) carbon atoms, and preferably one carbon atom. Examples of this group include $C_{2-9}$ alkenyl-O-$C_{1-8}$ alkylene-, preferably $C_{2-4}$ alkenyl-O-$C_{1-3}$ alkylene-, more preferably $C_{2-4}$ alkenyl-O-$C_{1-2}$ alkylene-, and particularly preferably $C_3$ alkenyl-O-$CH_2$-. More specific examples include $CH_2$=CH-O-$CH_2$-, $CH_2$=CH-$CH_2$-O-$CH_2$-, $CH_2$=CH-$CH_2$-O-$(CH_2)_2$-, $CH_2$=CH-$(CH_2)_3$-O-$(CH_2)_4$-, and the like; preferable among these is $CH_2$=CH-$CH_2$-O-$CH_2$- (an allyloxymethyl group).

Specific preferable examples of the compound represented by the formula (4) include 1,3-butadiene monoepoxide, 1,2-epoxy-5-hexene, 1,2-epoxy-9-decene, allyl glycidyl ether, and the like.

The epoxy resin represented by the formula (1) can be produced by hydrosilylation of the compound represented by the formula (3) and the compound represented by the formula (4). Hydrosilylation can be generally performed in the presence of a catalyst in the presence or absence of a solvent.

The catalyst used in hydrosilylation may be a known catalyst. Examples include platinum-based catalysts, such as platinum carbon, chloroplatinic acid, olefin complexes of platinum, alkenylsiloxane complexes of platinum, and carbonyl complexes of platinum; rhodium-based catalysts, such as tris(triphenylphosphine)rhodium; and iridium-based catalysts, such as bis(cyclooctadienyl)dichloroiridium. These catalysts may be in the form of solvates (e.g., hydrates, alcoholates, etc.). Further, the catalyst may be used in the form of a solution obtained by dissolving the catalyst in an alcohol (e.g., ethanol) when used. The catalysts can be used singly or in combination of two or more.

The amount of the catalyst used may be an effective amount as the catalyst, and is not particularly limited. The amount of the catalyst used is generally 0.00001 to 20 parts by mass, and preferably 0.0005 to 5 parts by mass, based on the total amount of 100 parts by mass of the compound represented by the formula (3) and the compound represented by the formula (4).

Although hydrosilylation proceeds without the use of a solvent, the reaction can be carried out under milder conditions by using a solvent. Examples of solvents include aromatic hydrocarbon solvents, such as toluene and xylene; aliphatic hydrocarbon solvents, such as hexane and octane; ether solvents, such as tetrahydrofuran and dioxane; alcohol solvents, such as ethanol and isopropanol; and the like. These may be used singly or in combination of two or more.

The amount of the compound represented by the formula (4) is generally 0.5 to 2 mol, preferably 0.6 to 1.5 mol, and more preferably 0.8 to 1.2 mol, per mol of the Si-H group in the compound represented by the formula (3).

The reaction temperature is generally 20°C to 150°C, and preferably 50°C to 120°C. The reaction time is

generally about 1 hour to 24 hours.

After completion of the reaction, for example, the solvent is distilled off from the reaction mixture by a known isolation method, thereby obtaining an epoxy resin represented by the formula (1).

The content of the epoxy resin represented by the formula (1) in the epoxy resin composition of the present invention is not particularly limited. The content of the epoxy resin is preferably 1 to 99 mass%, more preferably 1 to 50 mass%, even more preferably 2 to 40 mass%, still more preferably 3 to 30 mass%, and particularly preferably 5 to 20 mass%.

The epoxy resin composition of the present invention comprises a filler. In consideration of flowability, heat resistance, low-thermal expansibility, mechanical characteristics, hardness, scratch resistance, adhesion, and the like that are required for compositions and cured products, fillers can be used singly or as a mixture of two or more.

Examples of fillers usable in the present invention include inorganic compounds, such as silica (specifically crystalline silica, fused silica, spherical fused silica, etc.), titanium oxide, zirconium oxide, zinc oxide, tin oxide, silicon nitride, silicon carbide, boron nitride, calcium carbonate, calcium silicate, potassium titanate, aluminium nitride, indium oxide, alumina, antimony oxide, cerium oxide, magnesium oxide, iron oxide, and tin-doped indium oxide (ITO). Other examples include metal, such as gold, silver, copper, aluminum, nickel, iron, zinc, and stainless steel. Still other examples include minerals, such as montmorillonite, talc, mica, boehmite, kaolin, smectite, zonolite, vermiculite, and sericite. Other fillers include carbon compounds, such as carbon black, acetylene black, Ketchen black, and carbon nanotubes; metal hydroxides, such as aluminium hydroxide and magnesium hydroxide; various types of glass, such as glass beads, glass flakes, and glass balloons; and the like. A powder filler may be used as it is, or a filler dispersed in resin may also be used.

Preferable among these are alumina, calcium carbonate, crystalline silica, fused silica, spherical fused silica, boron nitride, and talc.

Because the epoxy resin represented by the formula (1) of the present invention contains a silicon atom, the filler is preferably a silicon atom-containing filler (e.g., silica; more specifically crystalline silica, fused silica, spherical fused silica, etc.). When the epoxy resin represented by the formula (1) of the present invention is combined with a silicon atom-containing filler, a more excellent low viscosity and higher flow characteristics can be exhibited due to the good compatibility between them.

The average particle size of the filler used is generally 0.05 to 50 $\mu$m, preferably 0.1 to 30 $\mu$m, and more preferably 0.1 to 20 $\mu$m. The average particle size can be measured by a known method. For example, the average particle size of alumina, calcium carbonate, crystalline silica, fused silica, spherical fused silica, boron nitride, or talc is measured by a laser diffraction scattering method.

Moreover, these fillers may be used after their surface is treated with a coupling agent, if necessary.

The amount of the filler in the resin composition of the present invention can be suitably selected depending on the type of filler. The mass ratio of the epoxy resin and filler in the resin composition of the present invention is preferably 1:1 to 10, more preferably 1:2 to 9, and even more preferably 1:6 to 8.5. The amount of epoxy resin in this case is, when the resin composition of the present invention contains an epoxy resin other than the epoxy resin represented by the formula (1), the total amount of all the epoxy resins (the total epoxy resin amount). Moreover, the proportion of the filler is preferably 1 to 99 mass%, more preferably 40 to 95 mass%, even more preferably 50 to 95 mass%, and still more preferably 60 to 95 mass%, based on the total mass of the epoxy resin composition (including the filler).

A filler dispersant can be used in the present invention. Examples of filler dispersants include polycarboxylic acid-based dispersants; silane coupling agents; titanate-based coupling agents; silicone-based dispersants, such as modified silicone oil; organic copolymer-based dispersants; and the like. The proportion of such a dispersant when mixed in the resin composition of the present invention is preferably 0.001 to 30 mass%, and more preferably 0.05 to 5 mass%, based on the total mass of the resin composition of the present invention.

The epoxy resin composition of the present invention may contain an epoxy resin other than the epoxy resin represented by the formula (1). The other epoxy resin is not particularly limited. Examples include bisphenol A epoxy resins, bisphenol F epoxy resins, phenol novolak epoxy resins, cresol novolak epoxy resins, cycloaliphatic epoxy resins, brominated epoxy resins, triglycidyl isocyanurate, hydrogenated bisphenol A epoxy resins, aliphatic epoxy resins, glycidyl ether epoxy resins, bisphenol S epoxy resins, biphenyl epoxy resins, dicyclo epoxy resins, naphthalene epoxy resins, and the like. These epoxy resins may be used singly or in combination of two or more.

When an epoxy resin other than the epoxy resin represented by the formula (1) is mixed, the proportion of the other epoxy resin may be within a range in which the effects of the present invention can be exhibited. In this case, the proportion of the epoxy resin other than the epoxy resin represented by the formula (1) is, for example, 99 mass% or less, and preferably 95 to 5 mass%, based on the total mass of the epoxy resins contained in the epoxy resin composition of the present invention. The proportion of the epoxy resin represented by the formula (1) is, for example, 1 mass% or more, and preferably 5 to 100 mass%. The mixing ratio of the epoxy resin represented by the formula (1) and the epoxy resin other than the epoxy resin represented by the formula (1) is, for example, 100:0 to 1:99, preferably 100:0 to 5:95, and more preferably 100:0 to 10:90, in terms of mass ratio.

The epoxy resin composition of the present invention contains a curing agent.

The curing agent is at least one member from the group consisting of amine-based curing agents and acid anhydride-based curing agents.

Examples of amine-based curing agents include chain aliphatic amines, such as ethylenediamine, diethylenetriamine, triethylenetetramine, and tetraethylenepentamine; alicyclic amines, such as isophoronediamine, menthenediamine, bis(4-aminocyclohexyl)methane, bis(aminomethyl)cyclohexane, and diaminodicyclohexylmethane; aromatic amines, such as meta-phenylenediamine, diaminodiphenylmethane, diethyltoluenediamine, and diaminodiethyldiphenylmethane; secondary and tertiary amines, such as benzyldimethylamine, triethylenediamine, piperidine, 2-(dimethylaminomethyl)phenol, 2,4,6-tris(dimethylaminomethyl)phenol, DBU (1,8-diazabicyclo(5,4,0)-undecene-7), and DBN (1,5-diazabicyclo(4,3,0)-nonene-5); and the like.

Examples of acid anhydride-based curing agents include aliphatic acid anhydrides, such as maleic anhydride and dodecenyl succinic anhydride; aromatic acid anhydrides, such as phthalic anhydride, trimellitic anhydride, and pyromellitic anhydride; alicyclic acid anhydrides, such as methylnadic anhydride, tetrahydrophthalic anhydride, methyltetrahydrophthalic anhydride, hexahydrophthalic anhydride, and 4-methylhexahydrophthalic anhydride; and the like.

The curing agents may be used singly. Moreover, they can be used separately depending on the required characteristics. Two or more curing agents may be used in combination.

The epoxy resin composition of the present invention may contain a curing accelerator. In particular, curing accelerators, when used in combination with curing agents, can increase the curing reaction rate, or increase the strength of cured products to be obtained. The curing accelerator is not particularly limited, as long as it can react with epoxy resins to obtain cured products.

Examples of the curing accelerator include imidazole compounds, such as imidazole, 2-methylimidazole, 2-ethylimidazole, 2-ethyl-4-methylimidazole, and 2-phenylimidazole; dicyandiamide and derivatives thereof; tertiary amines, such as DBU (1,8-diazabicyclo(5,4,0)-undecene-7), DBN (1,5-diazabicyclo(4,3,0)-nonene-5), and 2,4,6-tris(dimethylaminomethyl)phenol; phosphorus-based compounds; and the like.

Of these, preferable curing agents are acid anhydride-based curing agents and amine-based curing agents in terms of flowability. Moreover, preferable curing accelerators are tertiary amines, imidazole compounds, and phosphorus-based compounds.

The curing accelerators may be used singly. Moreover, they can be used separately depending on the required characteristics. Two or more curing accelerators may be used in combination.

The amount of the curing agent is not particularly limited. For example, the reactive functional group equivalent of the curing agent is preferably 0.1 to 5 equivalents, more preferably 0.3 to 3 equivalents, and even more preferably 0.5 to 2 equivalents, per equivalent of the epoxy group in the entire epoxy resin.

The amount of the curing accelerator is not particularly limited. For example, the amount of the curing accelerator is preferably 0.01 to 10 parts by mass, more preferably 0.1 to 5 parts by mass, and even more preferably 0.5 to 3 parts by mass, based on 100 parts by mass of the entire epoxy resin.

The epoxy resin composition of the present invention may optionally contain additives within a range that does not impair the objects and effects of the present invention.

Examples of additives include antioxidants, inorganic fluorescent substances, lubricants, ultraviolet absorbers, heat light stabilizers, antistatic agents, polymerization inhibitors, antifoaming agents, solvents, anti-aging agents, radical inhibitors, adhesion-improving agents, flame retardants, surfactants, storage stability-improving agents, ozone aging inhibitors, thickeners, plasticizers, radiation-blocking agents, nucleating agents, coupling agents, conductivity-imparting agents, phosphorus-based peroxide-decomposing agents, pigments, metal deactivators, physical property-controlling agents, and the like.

The epoxy resin composition of the present invention can be produced by mixing the epoxy resin represented by the formula (1) and a filler, and further optionally other components. The mixing method is not particularly limited, as long as it allows uniform mixing. The epoxy resin composition of the present invention has a low viscosity even when it is prepared without adding a solvent (e.g., toluene, methyl ethyl ketone, or acetone); however, a solvent may be added, if necessary, within a range that does not adversely affect the effects of the present invention.

A cured product (i.e., a product obtained by curing the epoxy resin composition) can be obtained by curing the epoxy resin composition of the present invention. The curing method is not particularly limited; for example, the composition can be cured by heating. The curing temperature is generally room temperature to 200°C. The curing time varies depending on the composition liquid, and can be generally widely set from 30 minutes to 1 week.

Because it comprises the epoxy resin represented by the formula (1), the epoxy resin composition of the present invention has a lower viscosity and superior flowability, compared with epoxy resin compositions comprising a general epoxy resin, such as a Bis-A epoxy resin. The viscosity of the epoxy resin composition of the present invention can be adjusted by the filler content, the type and content of other components, etc., and can be varied depending on the application. The viscosity of the epoxy resin composition of the present invention is generally about 500 Pa·s or less, preferably about 1 to 300 Pa·s, more preferably 1 to 100 Pa·s, and even more preferably about 1 to 30 Pa·s. The above viscosity is a value measured by a rheometer (e.g., AR2000ex, produced by TA Instruments Japan Inc.) using parallel

plates with a diameter of 60 mm at a shear rate of 10/s at 25°C.

Moreover, the epoxy resin composition of the present invention has high adhesion strength to metal, such as copper and aluminum. Furthermore, a cured product of the epoxy resin composition of the present invention has good electric characteristics (low dielectric constant and low dielectric loss tangent) and good water absorption characteristics.

Therefore, for example, the epoxy resin composition of the present invention can be suitably used for applications, such as semiconductor sealing materials, liquid sealing materials, underfill materials, potting materials, sealing materials, printed circuit board materials, and composite materials. Among these, the epoxy resin composition of the present invention is preferred as semiconductor liquid sealing materials and underfill materials that seal gaps between semiconductor devices and substrates.

Furthermore, the present invention includes a semiconductor sealing material, a liquid sealing material, a potting material, a sealing material, a printed circuit board material, and a composite material, each of which uses the epoxy resin composition or a cured product thereof.

## Examples

The present invention is described in more detail below with reference to Examples; however, the present invention is not limited to only these Examples.

Production Example 1 (Production of Epoxy Resin A)

Allyl glycidyl ether (Neoallyl G, produced by Daiso Co., Ltd.; 5.9 g), 0.06 g of 2 wt% ethanol solution of hexachloroplatinic acid hexahydrate, and 100 g of toluene were placed in a 200-mL four-necked flask equipped with a stirrer, a thermometer, and a condenser in a nitrogen atmosphere. After the liquid temperature was raised to 70°C, 5.0 g of 1,4-bis(dimethylsilyl)benzene was slowly added dropwise, and the mixture was then stirred at 90°C for 4 hours. After the toluene was concentrated, 11.0 g of colorless transparent liquid (epoxy resin A) was obtained.

Production Example 2 (Production of Epoxy Resin B)

1,2-Epoxy-5-hexene (produced by Tokyo Chemical Industry Co., Ltd.; 7.9 g), 0.15 g of 2 wt% ethanol solution of hexachloroplatinic acid hexahydrate, and 80 g of toluene were placed in a 200-mL four-necked flask equipped with a stirrer, a thermometer, and a condenser in a nitrogen atmosphere. After the liquid temperature was raised to 70°C, 7.8 g of 1,4-bis(dimethylsilyl)benzene was slowly added dropwise, and the mixture was then stirred at 90°C for 7 hours. After the toluene was concentrated, 16.1 g of colorless transparent liquid (epoxy resin B) was obtained.

Examples 1 to 5 and Comparative Examples 1 to 7

Components in amounts shown in Tables 1 and 2 were each weighed in a cup, mixed by a rotation-revolution mixer (ARE-310, produced by Thinky Corporation) at 2000 rpm for 5 minutes, and then defoamed at 2200 rpm for 5 minutes, thereby preparing epoxy resin compositions.

The components in Tables 1 and 2 are as follows. The numerical value of each component in Tables 1 and 2 represents parts by mass.

- Epoxy resin C: polypropylene glycol diglycidyl ether (Epolite 400P, produced by Kyoeisha Chemical Co., Ltd.)
- Epoxy resin D: Bis-A epoxy resin (Grade 828, produced by Mitsubishi Chemical Corporation)
- Curing agent A: 4-methylhexahydrophthalic anhydride/hexahydrophthalic anhydride = 70/30 (MH-700, produced by New Japan Chemical Co., Ltd.)
- Curing agent B: diethyltoluenediamine (Ethacure 100, produced by Albemarle)
- Curing accelerator A: 2-ethyl-4-methylimidazole (2E4MZ, produced by Mitsubishi Chemical Corporation)
- Curing accelerator B: DBU (1,8-diazabicyclo(5,4,0)undecene-7) (produced by Tokyo Chemical Industry Co., Ltd.)
- Filler A: spherical fused silica (MSR-5100, produced by Tatsumori Ltd.), average particle size: 17.8 μm
- Filler B: alumina (AS-40, produced by Showa Denko K.K.), average particle size: 12 μm

Test Example 1

(1) Viscosity

The viscosity at 25°C of the epoxy resin compositions obtained in Examples 1 to 5 and Comparative Examples 1 to 7 was measured using a rheometer (AR2000ex, produced by TA Instruments Japan Inc.) (parallel plates with a

diameter of 60 mm). The measurement result at a shear rate of 10/s was used as viscosity.

(2) Tensile Shear Adhesion Strength to Aluminum

The epoxy resin compositions obtained in Examples 1 to 5 and Comparative Examples 1 to 7 were each applied to an aluminum plate (size: 2 x 25 x 100 mm) so that the adhesive part had a rectangular shape (12.5 x 25 mm). Then, another aluminum plate was bonded thereto, and cured by heating at 100°C for 1 hour, 120°C for 2 hours, and 150°C for 2 hours. Thus, tensile shear test pieces were obtained.

The obtained test pieces were each subjected to a tensile shear adhesion test using a tensile tester (AGS-X, produced by Shimadzu Corp.) with a clamp distance of 100 mm at a test rate of 5 mm/min, and the tensile shear adhesion strength was calculated from the measured maximum breaking strength and the adhesion area. Tables 1 and 2 show the results.

(3) Tensile Shear Adhesion Strength to Copper

The epoxy resin compositions obtained in Examples 1 to 5 and Comparative Examples 1 to 7 were each applied to an oxygen-free copper plate (size: 2 x 25 x 100 mm) so that the adhesive part had a rectangular shape (12.5 x 25 mm). Then, an aluminum plate was bonded thereto, and cured by heating at 100°C for 1 hour, 120°C for 2 hours, and 150°C for 2 hours. Thus, tensile shear test pieces were obtained.

The obtained test pieces were each subjected to a tensile shear adhesion test using a tensile tester (AGS-X, produced by Shimadzu Corp.) with a clamp distance of 100 mm at a test rate of 5 mm/min, and the tensile shear adhesion strength was calculated from the measured maximum breaking strength and the adhesion area. Tables 1 and 2 show the results.

(4) Water Absorption Characteristics (Water Absorption)

The epoxy resin compositions obtained in Examples 1 to 5 and Comparative Examples 1 to 7 were each poured into a resin mold (thickness: 2 mm), cured by heating at 100°C for 1 hour, 120°C for 2 hours, and 150°C for 2 hours, and cut into a size of 20 mm in width x 30 mm in length x 2 mm in thickness. Thus, test pieces for water absorption measurement were obtained. The test pieces were dried and then immersed in water at 23°C for 24 hours, and the water absorption was determined by mass change before and after immersion.

$$\text{Water absorption (\%)} = (\text{mass before immersion} - \text{mass after immersion}) / \text{mass before immersion} \times 100$$

(5) Electric Characteristics (Relative Dielectric Constant, Dielectric Loss Tangent)

The epoxy resin compositions obtained in Examples 1 to 5 and Comparative Examples 1 to 7 were each poured into a resin mold (thickness: 2 mm), cured by heating at 100°C for 1 hour, 120°C for 2 hours, and 150°C for 2 hours, and cut into a size of 20 mm in width x 30 mm in length x 2 mm in thickness. Thus, test pieces for dielectric measurement were obtained.

The relative dielectric constant (1 GHz) and the dielectric loss tangent (1 GHz) of the obtained test pieces were measured using a dielectric constant measuring device (Impedance Analyzer, produced by Agilent) calibrated with PTFE.

Table 1

| | | Example | | | | |
|---|---|---|---|---|---|---|
| | | 1 | 2 | 3 | 4 | 5 |
| Epoxy resin | Epoxy resin A | 10 | 2 | | 10 | 10 |
| | Epoxy resin B | | | 10 | | |
| | Epoxy resin C | | | | | |
| | Epoxy resin D | | 8 | | | |
| Curing agent A | | 9 | 9 | 9 | | 9 |
| Curing agent B | | | | | 2 | |

(continued)

| | | Example | | | | |
|---|---|---|---|---|---|---|
| | | 1 | 2 | 3 | 4 | 5 |
| Curing accelerator A | | 1 | 1 | 1 | | 1 |
| Curing accelerator B | | | | | 1 | |
| Filler | Filler A | 80 | 80 | 80 | 80 | |
| | Filler B | | | | | 80 |
| Viscosity 25°C (Pa·s) | | 2.3 | 19.7 | 1.8 | 5.9 | 1.9 |
| Tensile shear adhesion strength to aluminum (MPa) | | 4.8 | 2.4 | 3.8 | 7.8 | 4.4 |
| Tensile shear adhesion strength to copper (MPa) | | 10.4 | 3.4 | 10.3 | 11.2 | 13.2 |
| Water absorption (wt%) | | 0.2 | 0.2 | 0.2 | 0.2 | 0.2 |
| Relative dielectric constant (1 GHz) | | 3.3 | 3.4 | 3.1 | 3.4 | 5.5 |
| Dielectric loss tangent (1 GHz) | | 0.004 | 0.004 | 0.001 | 0.004 | 0.007 |

Table 2

| | | Comparative Example | | | | | | |
|---|---|---|---|---|---|---|---|---|
| | | 1 | 2 | 3 | 4 | 5 | 6 | 7 |
| Epoxy resin | Epoxy resin A | | | | | | | |
| | Epoxy resin B | | | | | | | |
| | Epoxy resin C | 10 | 2 | | 10 | | 10 | |
| | Epoxy resin D | | 8 | 10 | | 10 | | 10 |
| Curing agent A | | 9 | 9 | 9 | | | 9 | 9 |
| Curing agent B | | | | | 2 | 2 | | |
| Curing accelerator A | | 1 | 1 | 1 | | | 1 | 1 |
| Curing accelerator B | | | | | 1 | 1 | | |
| Filler | Filler A | 80 | 80 | 80 | 80 | 80 | | |
| | Filler B | | | | | | 80 | 80 |
| Viscosity 25°C (Pa·s) | | 2.5 | 40.2 | 34.2 | 6.0 | 900 | 2.1 | 31.7 |
| Tensile shear adhesion strength to aluminum (MPa) | | 0.1 | 2.0 | 2.8 | 0.1 | 3.0 | 0.1 | 2.4 |
| Tensile shear adhesion strength to copper (MPa) | | 0.1 | 3.3 | 2.5 | 0.1 | 4.2 | 0.2 | 3.6 |
| Water absorption (wt%) | | 0.7 | 0.2 | 0.2 | 0.8 | 0.2 | 1.0 | 0.2 |
| Relative dielectric constant (1 GHz) | | 3.5 | 3.4 | 3.4 | 3.4 | 3.4 | 6.0 | 5.6 |
| Dielectric loss tangent (1 GHz) | | 0.011 | 0.004 | 0.003 | 0.012 | 0.004 | 0.016 | 0.005 |

As shown in Tables 1 and 2, when the Examples using the epoxy resins of the present invention singly are compared with the Comparative Examples, the epoxy resin compositions of the Examples have a lower viscosity and superior adhesion.

In contrast, the epoxy resin compositions of the Comparative Examples comprising the epoxy resin C, which is a commonly used epoxy resin, have a low viscosity; however, their adhesion to aluminum or copper is poor, and their water absorption and electric characteristics are also inferior.

Moreover, the epoxy resin compositions of the Comparative Examples comprising the epoxy resin D, which is another commonly used epoxy resin, have good adhesion; however, their viscosity is relatively high, and it is difficult to use them to fill a narrow gap.

Furthermore, when Example 2 and Comparative Example 2, both of which used a composition obtained by mixing an epoxy resin and another epoxy resin, are compared, the epoxy resin composition of Example 2 has a low viscosity even though a large amount of filler is mixed, whereas the epoxy resin composition of Comparative Example 2 shows a relatively high viscosity.

## Claims

1. An epoxy resin composition comprising an epoxy resin, a curing agent and a filler, the epoxy resin being represented by the formula (1):

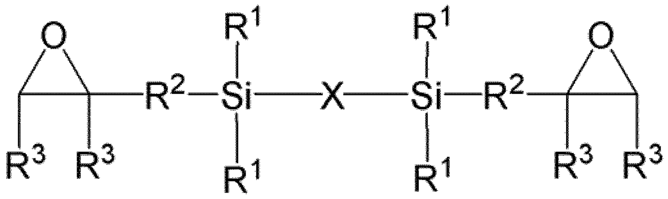

(1)

wherein X is a divalent group obtained by removing two hydrogen atoms from a hydrocarbon ring, or a divalent group represented by the formula (2):

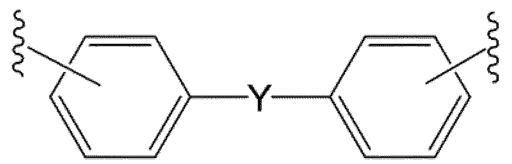

(2)

wherein Y is a bond, a $C_{1-6}$ alkylene group, an oxygen atom (-0-), or $-S(O)_m-$ wherein m is 0, 1, or 2;

$R^1$ is the same or different, and is a $C_{1-18}$ alkyl group, a $C_{2-9}$ alkenyl group, a cycloalkyl group, an aryl group, or an aralkyl group, wherein one or more carbon atoms of these groups may be replaced by at least one atom selected from the group consisting of an oxygen atom and a nitrogen atom;
$R^2$ is the same or different, and is a $C_{1-18}$ alkylene group, wherein one or more carbon atoms of this group other than a carbon atom directly bonded to a silicon atom may be replaced by at least one atom selected from the group consisting of an oxygen atom and a nitrogen atom; and
$R^3$ is the same or different, and is a hydrogen atom, a $C_{1-18}$ alkyl group, a $C_{2-9}$ alkenyl group, a cycloalkyl group, an aryl group, or an aralkyl group, wherein one or more carbon atoms of these groups may be replaced by at least one atom selected from the group consisting of an oxygen atom and a nitrogen atom, and the curing agent being at least one member selected from the group consisting of acid anhydride-based curing agents and amine-based curing agents.

2. The epoxy resin composition according to claim 1, wherein the epoxy resin is represented by the formula (1a):

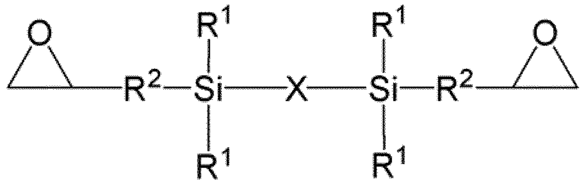

(1a)

wherein $R^1$, $R^2$, and X are as defined above.

3. The epoxy resin composition according to claim 2, wherein

X is a 1,4-phenylene group or a group represented by the formula (2a) :

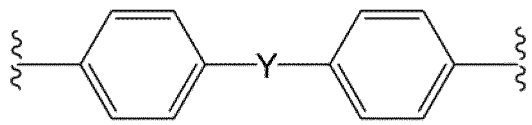

(2a)

wherein Y is as defined above,

$R^1$ is the same or different, and is a $C_{1-3}$ alkyl group, and
$R^2$ is the same or different, and is a $C_{2-6}$ alkylene group, (*)-$(CH_2)_2$-O-$CH_2$-, (*)-$(CH_2)_3$-O-$CH_2$-, (*)-$(CH_2)_3$-O-$(CH_2)_2$-, or (*)-$(CH_2)_5$-O-$(CH_2)_4$-, wherein (*) represents the side of $R^2$ binding to the silicon atom.

**4.** The epoxy resin composition according to claim 1, 2, or 3, wherein the filler is at least one member selected from the group consisting of alumina, calcium carbonate, crystalline silica, fused silica, spherical fused silica, boron nitride, and talc.

**5.** A cured product of the epoxy resin composition according to any one of claims 1 to 4.

**6.** A method for producing the epoxy resin composition according to any one of claims 1 to 4 or the cured product according to claim 5, the method comprising mixing the epoxy resin represented by the formula (1) and the filler.

**7.** A semiconductor sealing material, a liquid sealing material, a potting material, a sealing material, a printed circuit board material, or a composite material, each of which uses the epoxy resin composition according to any one of claims 1 to 4 or the cured product according to claim 5.

**8.** The epoxy resin composition according to any one of claims 1 to 4 for use in a semiconductor sealing material, a liquid sealing material, a potting material, a sealing material, a printed circuit board material, or a composite material.

**9.** Use of the epoxy resin composition according to any one of claims 1 to 4 for producing a semiconductor sealing material, a liquid sealing material, a potting material, a sealing material, a printed circuit board material, or a composite material.

**10.** Use of an epoxy resin composition comprising an epoxy resin and a filler for producing a semiconductor sealing material, a liquid sealing material, a potting material, a sealing material, a printed circuit board material, or a composite material,
wherein the epoxy resin is represented by the formula (1) :

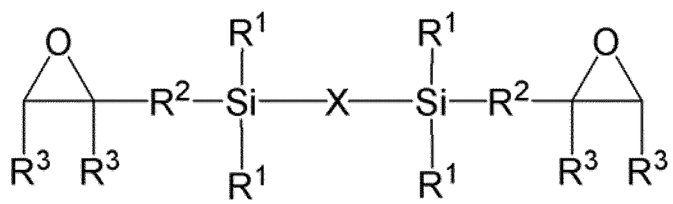

(1)

wherein X is a divalent group obtained by removing two hydrogen atoms from a hydrocarbon ring, or a divalent group represented by the formula (2):

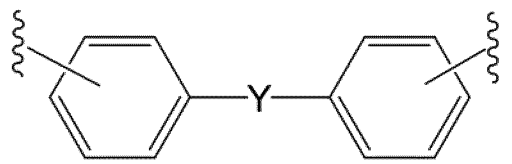

(2)

wherein Y is a bond, a $C_{1-6}$ alkylene group, an oxygen atom (-0-), or -S(O)$_m$- wherein m is 0, 1, or 2;

$R^1$ is the same or different, and is a $C_{1-18}$ alkyl group, a $C_{2-9}$ alkenyl group, a cycloalkyl group, an aryl group, or an aralkyl group, wherein one or more carbon atoms of these groups may be replaced by at least one atom selected from the group consisting of an oxygen atom and a nitrogen atom;
$R^2$ is the same or different, and is a $C_{1-18}$ alkylene group, wherein one or more carbon atoms of this group other than a carbon atom directly bonded to a silicon atom may be replaced by at least one atom selected from the group consisting of an oxygen atom and a nitrogen atom; and
$R^3$ is the same or different, and is a hydrogen atom, a $C_{1-18}$ alkyl group, a $C_{2-9}$ alkenyl group, a cycloalkyl group, an aryl group, or an aralkyl group, wherein one or more carbon atoms of these groups may be replaced by at least one atom selected from the group consisting of an oxygen atom and a nitrogen atom.

## Patentansprüche

**1.** Epoxidharzzusammensetzung, die ein Epoxidharz, einen Härter und einen Füllstoff umfasst, wobei das Epoxidharz durch Formel (1) dargestellt ist:

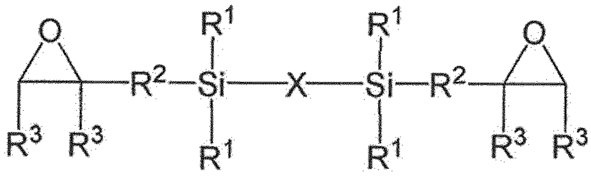
(1)

worin
X eine durch Entfernung zweier Wasserstoffatome aus einem Kohlenwasserstoffring erhaltene zweiwertige Gruppe ist oder eine durch Formel (2) dargestellte zweiwertige Gruppe ist:

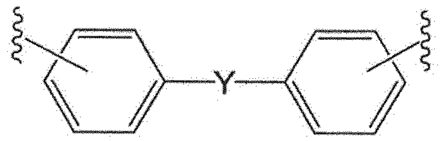
(2)

worin Y eine Bindung, eine $C_{1-6}$-Alkylengruppe, ein Sauerstoffatom (-O-) oder $-S(O)_m-$ ist, worin m = 0, 1 oder 2 ist;

die $R^1$ jeweils gleich oder unterschiedlich sind und eine $C_{1-18}$-Alkylgruppe, eine $C_{2-9}$-Alkenylgruppe, eine Cycloalkylgruppe, eine Arylgruppe oder eine Aralkylgruppe sind, worin gegebenenfalls ein oder mehrere Kohlenstoffatome dieser Gruppen durch zumindest ein Atom ersetzt sind, das aus der aus einem Sauerstoffatom und einem Stickstoffatom bestehenden Gruppe ausgewählt ist;
die $R^2$ jeweils gleich oder unterschiedlich sind und eine $C_{1-18}$-Alkylengruppe sind, worin gegebenenfalls ein oder mehrere Kohlenstoffatome dieser Gruppe, abgesehen von dem direkt an das Siliciumatom gebundenen Kohlenstoffatom, durch zumindest ein Atom ersetzt sind, das aus der aus einem Sauerstoffatom und einem Stickstoffatom bestehenden Gruppe ausgewählt ist;
die $R^3$ jeweils gleich oder unterschiedlich sind und ein Wasserstoffatom, eine $C_{1-18}$-Alkylgruppe, eine $C_{2-9}$-Alkenylgruppe, eine Cycloalkylgruppe, eine Arylgruppe oder eine Aralkylgruppe sind, worin gegebenenfalls ein oder mehrere Kohlenstoffatome dieser Gruppen durch zumindest ein Atom ersetzt sind, das aus der aus einem Sauerstoffatom und einem Stickstoffatom bestehenden Gruppe ausgewählt ist, und der Härter zumindest ein Element, ausgewählt aus der aus Härtern auf Säureanhydridbasis und Härtern auf Aminbasis bestehenden Gruppe ist.

**2.** Epoxidharzzusammensetzung nach Anspruch 1, wobei das Epoxidharz durch Formel (1a) dargestellt ist:

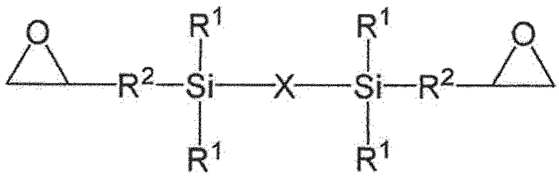
(1a)

worin $R^1$, $R^2$ und X wie oben definiert sind.

3. Epoxidharzzusammensetzung nach Anspruch 2, worin X eine 1,4-Phenylengruppe oder eine durch Formel (2a) dargestellte Gruppe ist:

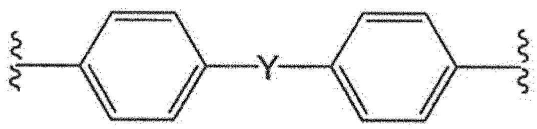

(2a)

worin Y wie oben definiert ist,

die $R^1$ jeweils gleich oder unterschiedlich sind und eine $C_{1-3}$-Alkylgruppe sind und die $R^2$ jeweils gleich oder unterschiedlich sind und eine $C_{2-6}$-Alkylengruppe, (*)-$(CH_2)_2$-O-$CH_2$-, (*)-$(CH_2)_3$-O-$CH_2$-, (*)-$(CH_2)_3$-O-$(CH_2)_2$- oder (*)-$(CH_2)_5$-O-$(CH_2)_4$- sind, worin (*) die Seite der Bindung von $R^2$ an das Siliciumatom darstellt.

4. Epoxidharzzusammensetzung nach Anspruch 1, 2 oder 3, wobei der Füllstoff zumindest ein Element, ausgewählt aus der aus Aluminiumoxid, Calciumcarbonat, kristallinem Siliciumdioxid, Quarzglas, kugelförmigem Quarzglas, Bornitrid und Talk bestehenden Gruppe ist.

5. Gehärtetes Produkt aus einer Epoxidharzzusammensetzung nach einem der Ansprüche 1 bis 4.

6. Verfahren zur Herstellung einer Epoxidharzzusammensetzung nach einem der Ansprüche 1 bis 4 oder eines gehärteten Produkts nach Anspruch 5, wobei das Verfahren das Vermischen eines durch Formel (1) dargestellten Epoxidharzes und eines Füllstoffs umfasst.

7. Halbleiter-Dichtungsmaterial, flüssiges Dichtungsmaterial, Vergussmaterial, Dichtungsmaterial, Leiterplattenmaterial oder Verbundmaterial, das jeweils eine Epoxidharzzusammensetzung nach einem der Ansprüche 1 bis 4 oder ein gehärtetes Produkt nach Anspruch 5 umfasst.

8. Epoxidharzzusammensetzung nach einem der Ansprüche 1 bis 4 zur Verwendung in einem Halbleiter-Dichtungsmaterial, einem flüssigen Dichtungsmaterial, einem Vergussmaterial, einem Dichtungsmaterial, einem Leiterplattenmaterial oder einem Verbundmaterial.

9. Verwendung einer Epoxidharzzusammensetzung nach einem der Ansprüche 1 bis 4 zur Herstellung eines Halbleiter-Dichtungsmaterials, eines flüssigen Dichtungsmaterials, eines Vergussmaterials, eines Dichtungsmaterials, eines Leiterplattenmaterials oder eines Verbundmaterials.

10. Verwendung einer Epoxidharzzusammensetzung, die ein Epoxidharz und einen Füllstoff zur umfasst, Herstellung eines Halbleiter-Dichtungsmaterials, eines flüssigen Dichtungsmaterials, eines Vergussmaterials, eines Dichtungsmaterials, eines Leiterplattenmaterials oder eines Verbundmaterials,
wobei das Epoxidharz durch Formel (1) dargestellt ist:

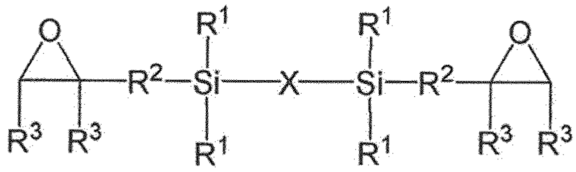

(1)

worin
X eine durch Entfernung zweier Wasserstoffatome aus einem Kohlenwasserstoffring erhaltene zweiwertige Gruppe ist oder eine durch Formel (2) dargestellte zweiwertige Gruppe ist:

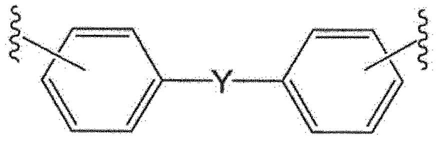

(2)

worin Y eine Bindung, eine $C_{1-6}$-Alkylengruppe, ein Sauerstoffatom (-O-) oder $-S(O)_m-$ ist, worin m = 0, 1 oder 2 ist;

die $R^1$ jeweils gleich oder unterschiedlich sind und eine $C_{1-18}$-Alkylgruppe, eine $C_{2-9}$-Alkenylgruppe, eine Cycloalkylgruppe, eine Arylgruppe oder eine Aralkylgruppe sind, worin gegebenenfalls ein oder mehrere Kohlenstoffatome dieser Gruppen durch zumindest ein Atom ersetzt sind, das aus der aus einem Sauerstoffatom und einem Stickstoffatom bestehenden Gruppe ausgewählt ist;
die $R^2$ jeweils gleich oder unterschiedlich sind und eine $C_{1-18}$-Alkylengruppe sind, worin gegebenenfalls ein oder mehrere Kohlenstoffatome dieser Gruppe, abgesehen von dem direkt an das Siliciumatom gebundenen Kohlenstoffatom, durch zumindest ein Atom ersetzt sind, das aus der aus einem Sauerstoffatom und einem Stickstoffatom bestehenden Gruppe ausgewählt ist; und
die $R^3$ jeweils gleich oder unterschiedlich sind und ein Wasserstoffatom, eine $C_{1-18}$-Alkylgruppe, eine $C_{2-9}$-Alkenylgruppe, eine Cycloalkylgruppe, eine Arylgruppe oder eine Aralkylgruppe sind, worin gegebenenfalls ein oder mehrere Kohlenstoffatome dieser Gruppen durch zumindest ein Atom ersetzt sind, das aus der aus einem Sauerstoffatom und einem Stickstoffatom bestehenden Gruppe ausgewählt ist.

## Revendications

1. Composition de résine époxy comprenant une résine époxy, un agent durcisseur et une charge, la résine époxy étant représentée par la formule (1) :

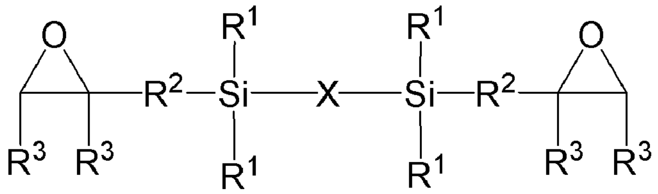

(1)

dans laquelle X est un groupe divalent obtenu par élimination de deux atomes d'hydrogène sur un cycle hydrocarboné, ou un groupe divalent représenté par la formule (2) :

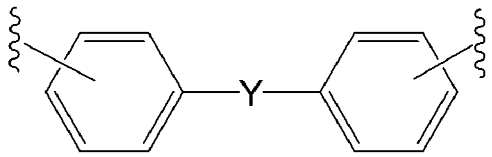

(2)

dans laquelle Y est une liaison, un groupe alkylène en $C_1$ à $C_6$, un atome d'oxygène (-O-), ou $-S(O)_m-$ où m vaut 0, 1 ou 2 ;

les $R^1$ sont identiques ou différents et sont un groupe alkyle en $C_1$ à $C_{18}$, un groupe alcényle en $C_2$ à $C_9$, un groupe cycloalkyle, un groupe aryle, ou un groupe aralkyle, un ou plusieurs atomes de carbone de ces groupes pouvant être remplacés par au moins un atome choisi dans l'ensemble constitué par un atome d'oxygène et un atome d'azote ;
les $R^2$ sont identiques ou différents et sont un groupe alkylène en $C_1$ à $C_{18}$, un ou plusieurs atomes de carbone de ce groupe autres qu'un atome de carbone directement lié à un atome de silicium pouvant être remplacés par au moins un atome choisi dans l'ensemble constitué par un atome d'oxygène et un atome d'azote ; et
les $R^3$ sont identiques ou différents et sont un atome d'hydrogène, un groupe alkyle en $C_1$ à $C_{18}$, un groupe

alcényle en $C_2$ à $C_9$, un groupe cycloalkyle, un groupe aryle, ou un groupe aralkyle, un ou plusieurs atomes de carbone de ces groupes pouvant être remplacés par au moins un atome choisi dans l'ensemble constitué par un atome d'oxygène et un atome d'azote,
et l'agent durcisseur étant au moins un membre choisi dans l'ensemble constitué par les agents durcisseurs à base d'anhydride d'acide et les agents durcisseurs à base d'amine.

**2.** Composition de résine époxy selon la revendication 1, dans laquelle la résine époxy est représentée par la formule (1a) :

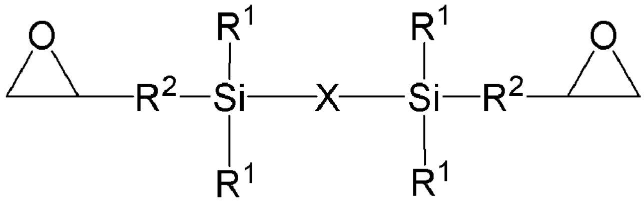

(1a)

dans laquelle $R^1$, $R^2$ et X sont tels que définis ci-dessus.

**3.** Composition de résine époxy selon la revendication 2, dans laquelle
X est un groupe 1,4-phénylène ou un groupe représenté par la formule (2a) :

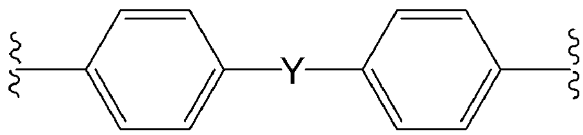

(2a)

dans laquelle Y est tel que défini ci-dessus,

les $R^1$ sont identiques ou différents, et sont un groupe alkyle en $C_1$ à $C_3$, et
les $R^2$ sont identiques ou différents, et sont un groupe alkylène en $C_2$ à $C_6$, $(*)-(CH_2)_2-O-CH_2-$, $(*)-(CH_2)_3-O-CH_2-$, $(*)-(CH_2)_3-O-(CH_2)_2-$, ou $(*)-(CH_2)_5-O-(CH_2)_4-$, où (*) représente le côté de $R^2$ se liant à l'atome de silicium.

**4.** Composition de résine époxy selon la revendication 1, 2 ou 3, dans laquelle la charge est au moins un membre choisi dans l'ensemble constitué par l'alumine, le carbonate de calcium, la silice cristalline, le verre de silice, le verre de silice sphérique, le nitrure de bore, et le talc.

**5.** Produit durci de la composition de résine époxy de l'une quelconque des revendications 1 à 4.

**6.** Procédé pour produire la composition de résine époxy de l'une quelconque des revendications 1 à 4 ou le produit durci de la revendication 5, le procédé comprenant le mélange de la résine époxy représentée par la formule (1) et de la charge.

**7.** Matériau d'étanchéité de semi-conducteur, matériau d'étanchéité liquide, matériau d'enrobage, matériau d'étanchéité, matériau de carte de circuit imprimé, ou matériau composite, utilisant chacun la composition de résine époxy de l'une des revendications 1 à 4 ou le produit durci de la revendication 5.

**8.** Composition de résine époxy selon l'une quelconque des revendications 1 à 4 pour une utilisation dans un matériau d'étanchéité de semi-conducteur, un matériau d'étanchéité liquide, un matériau d'enrobage, un matériau d'étanchéité, un matériau de carte de circuit imprimé, ou un matériau composite.

**9.** Utilisation de la composition de résine époxy de l'une quelconque des revendications 1 à 4 pour la production d'un matériau d'étanchéité de semi-conducteur, d'un matériau d'étanchéité liquide, d'un matériau d'enrobage, d'un matériau d'étanchéité, d'un matériau de carte de circuit imprimé, ou d'un matériau composite.

**10.** Utilisation d'une composition de résine époxy comprenant une résine époxy et une charge pour la production d'un matériau d'étanchéité de semi-conducteur, d'un matériau d'étanchéité liquide, d'un matériau d'enrobage, d'un matériau d'étanchéité, d'un matériau de carte de circuit imprimé, ou d'un matériau composite
dans laquelle la résine époxy est représentée par la formule (1) :

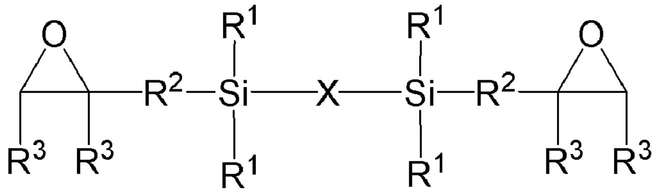

(1)

dans laquelle X est un groupe divalent obtenu par élimination de deux atomes d'hydrogène sur un cycle hydrocarboné, ou un groupe divalent représenté par la formule (2) :

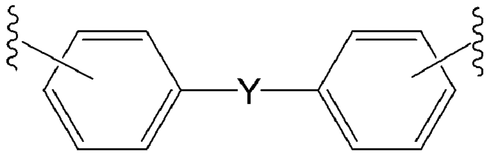

(2)

dans laquelle Y est une liaison, un groupe alkylène en $C_1$ à $C_6$, un atome d'oxygène (-O-), ou $-S(O)_m-$ où m vaut 0, 1 ou 2 ;

les $R^1$ sont identiques ou différents et sont un groupe alkyle en $C_1$ à $C_{18}$, un groupe alcényle en $C_2$ à $C_9$, un groupe cycloalkyle, un groupe aryle, ou un groupe aralkyle, un ou plusieurs atomes de carbone de ces groupes pouvant être remplacés par au moins un atome choisi dans l'ensemble constitué par un atome d'oxygène et un atome d'azote ;
les $R^2$ sont identiques ou différents et sont un groupe alkylène en $C_1$ à $C_{18}$, un ou plusieurs atomes de carbone de ce groupe autres qu'un atome de carbone directement lié à un atome de silicium pouvant être remplacés par au moins un atome choisi dans l'ensemble constitué par un atome d'oxygène et un atome d'azote ; et
les $R^3$ sont identiques ou différents et sont un atome d'hydrogène, un groupe alkyle en $C_1$ à $C_{18}$, un groupe alcényle en $C_2$ à $C_9$, un groupe cycloalkyle, un groupe aryle, ou un groupe aralkyle, un ou plusieurs atomes de carbone de ces groupes pouvant être remplacés par au moins un atome choisi dans l'ensemble constitué par un atome d'oxygène et un atome d'azote.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2006005369 A1
- WO 2012105071 A1
- JP 2012162585 A
- GB 1123960 A